# EUROPÄISCHE PATENTSCHRIFT

(11) **EP 0 557 896 B1**
(45) Veröffentlichungstag und Bekanntmachung des Hinweises auf die Patenterteilung: **03.05.1995**
(21) Anmeldenummer: 93102595.1
(22) Anmeldetag: 19.02.1993
(51) Int. Cl.: H05K 9/00, C08G 18/42, C08G 18/66, C08G 18/76

(54) **Kabeldurchführung für EMV-dichte Schränke**
Cable lead-through for EMI shielded cabinets
Traversée de câbles pour des panneaux étanches aux rayonnements électromagnétiques

(30) Priorität: 27.02.1992 DE 4205967
(43) Veröffentlichungstag der Anmeldung: 01.09.1993
(73) Patentinhaber: Alcatel SEL Aktiengesellschaft, D-70435 Stuttgart (DE)
(72) Erfinder: Steffen, Günter, W-7254 Hemmingen (DE)
(74) Vertreter: Pohl, Herbert, Dipl.-Ing.

(56) Entgegenhaltungen:
- DE-A- 4 013 886
- DE-U- 8 622 101
- US-A- 3 830 954

## Beschreibung

Die Erfindung betrifft eine Kabeldurchführung für EMV-dichte Schränke, insbesondere zur Verwendung in der Nachrichtentechnik.

Derartige Schränke enthalten zunehmend Einrichtungen für digitale Nachrichtensysteme mit störempfindlichen elektronischen Schaltungen, die mit von außen herangeführten, abgeschirmten Anschlußleitungen oder Kabeln verbunden sind. Um einen möglichst lückenlosen Übergang von der Kabelabschirmung zum EMV-dicht abgeschirmten Schrank zu erreichen, ist aus dem DE-GM 86 22 101 bekannt, beispielsweise in der Deckplatte wenigstens eine als relativ langer Schlitz ausgebildete Öffnung zum Hindurchführen einer Reihe Anschlußkabel und eine noch verbleibende Lücken schließende Abschirmvorrichtung vorzusehen.

Die Abschirmvorrichtung hat zwei dicht nebeneinander liegende Gummischnüre, die jeweils mit einem Metallgeflecht überzogen sind und von kabelschellenartigen Haltern gegen die zwischen den Schnüren hindurchgeführten Anschlußkabel angedrückt werden.

Die schienenförmig gestalteten Halter haben Langlöcher, die eine Verschiebung der Halter gestatten. Bei der Montage mehrerer Anschlußkabel werden entsprechende Befestigungsschrauben der Halter gelöst und diese mit den Gummischnüren auseinandergeschoben, die Anschlußkabel in einer Reihe nebeneinander hindurchgeführt, die Halter danach bis zur gegenseitigen Berührung der Schnüre gegeneinander zurückgeschoben und wieder an die Gehäusewand geschraubt. Eine solche HF-dichte Kabeldurchführung führt hinsichtlich der Abschirmwirkung zwar zu recht guten Ergebnissen, jedoch ist sie für einige Anwendungsfälle nicht geeignet.

Die Erfindung liegt die Aufgabe zugrunde, eine Kabeldurchführung für EMV-dichte Schränke zu schaffen, die einen abgeschirmten Durchtritt von unterschiedlich umfangreichen Kabelbündeln gestattet. Gelöst wird diese Aufgabe mit den im Anspruch 1 angegebenen konstruktiven Merkmalen. Zweckmäßige Ausgestaltungen der Kabeldurchführung sind den Unteransprüchen zu entnehmen. Die Lösung hat unter anderem den Vorteil, daß die Durchführung der Baugruppe selbst störstrahlungsdicht ist und sowohl für sich allein als auch zu mehreren nebeneinander EMV-dicht in eine entsprechende Öffnung der Schrankdecke eingesetzt werden kann. Die so abgeschirmte Kabeldurchführung verhindert daher das Eindringen und Austreten elektromagnetischer Störstrahlung und erfüllt somit die Forderungen bestehender Normen. Außerdem kann die Baugruppe aus relativ einfach herstellbaren Blechteilen zusammengefügt und ohne besondere Fachkenntnisse sicher montiert werden.

Die Erfindung wird anhand eines in Zeichnungen dargestellten Ausführungsbeispieles wie folgt näher beschrieben. In den Zeichnungen zeigen:
- Fig. 1: ein Gehäuse mit dem Durchführungsteil der Kabeldurchführung, teilweise ausgeschnitten, in perspektivischer Ansicht;
- Fig. 2: eine Andruckvorrichtung der Kabeldurchführung, teilweise ausgeschnitten, in perspektivischer Ansicht.

Die Kabeldurchführung besteht aus einer Baugruppe, die aus einem Gehäuse 1, einem daran befestigten Durchführungsteil 2 und einer unterhalb des Durchführungsteiles 2 in das Gehäuse 1 eingeschobenen Andruckvorrichtung 3 zusammengesetzt ist.

Bei dem Gehäuse 1 handelt es sich um einen im wesentlichen quaderförmigen, aus mehreren Blechteilen zusammengefügten Kasten, der in Einbaulage hochkant steht und an der Unterseite offen sein kann. Als Befestigungsmittel dienen beispielsweise eine an der oberen Kante der Rückwand vorgesehene Halteschiene und ein an der Unterseite des Gehäuses 1 etwas längerer Teil 4 der Rückwand. In einem EMV-dichten Schrank wird das Gehäuse 1 beispielsweise durch Einhängen an einer Schrankwand und Anschrauben des unteren Teiles der Gehäuserückwand befestigt.

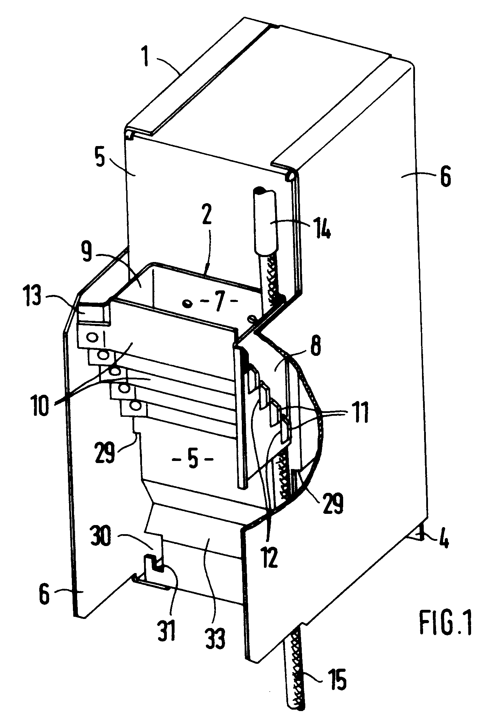

Wie Fig. 1 zeigt, hat das Gehäuse 1 an der als Frontplatte 5 dienenden Vorderseite vorgezogene Seitenwände 6, zwischen denen das Durchführungsteil 2 befestigt ist. Dieses besteht aus einer ebenen Grundplatte 7 mit an zwei parallel verlaufenden Kanten U-förmig hochgebogenen Seitenwänden 8, 9, zwischen denen sich mehrere, im wesentlichen streifenförmige Druckplatten 10 identischer Ausführung erstrecken. Die als einfache Stanzteile konzipierten Druckplatten 10 haben jeweils an einem Ende einen Ansatz 11, mit dem sie in treppenartig versetzte Schlitze 12, die in der einen Seitenwand 8 des Durchführungsteiles 2 ausgeschnitten sind, gesteckt werden. Mit dem anderen Ende werden sie an nach außen umgebogene und den Abständen der Schlitze 12 entsprechend treppenartig angeordnete Lappen 13 der gegenüberstehenden Seitenwand 9 geschraubt. Schlitze 12 und Lappen 13 sind hierbei so angeordnet, daß die befestigten Druckplatten 10 stets parallel zur Grundplatte 7 liegen. Da die Druckplatten 10 zweckmäßigerweise breiter sind als die in die Schlitze 12 steckbaren Ansätze 11 und das Ende, mit dem sie an die Lappen 13 geschraubt werden, erhalten sie eine einander überlappende Anordnung. Zur Grundplatte 7 hat die nächstliegende Druckplatte 10 einen Abstand, der kleiner ist als der Durchmesser des blanken Schirmgeflechtes 15 der für die Durchführung vorgesehenen, symmetrischen Kabel 14. Die anderen Druckplatten 10 haben jeweils denselben Abstand zueinander. Bei dem dargestellten Ausführungsbeispiel können auf diese Weise eine oder nacheinander bis zu fünf Kabellagen befestigt werden, wobei die Druckplatten 10 die eingelegten Kabel 14 jeweils mit definierter Kraft mechanisch fixieren, deren Schirmgeflecht 15 dabei elektrisch kontaktieren und mit Ausnahme der letzten Druckplatte 10 zugleich als Widerlager für die nächste Kabellage dienen. Ergibt die vorhandene Anzahl Kabel 14 keine vollständige Kabellage, werden die Lücken mit blinden Kabelstücken kurzer Länge gefüllt. Die Entstehung von Lücken zwischen den nebeneinander liegenden Kabeln 14 können beispielsweise mit an der Grundplatte 7 und den Druckplatten 10 angebrachten, elektrisch leitenden, elastischen Kissen oder Kontaktschläuchen geschlossen werden.

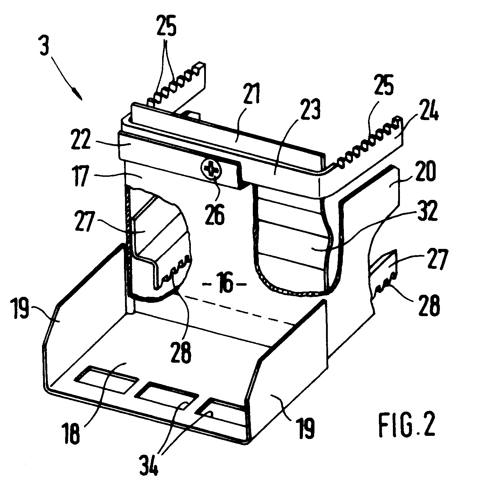

Die in Fig. 2 dargestellte Andruckvorrichtung 3 besteht im wesentlichen aus einem Basisteil 16, einer Andruckplatte 21, zwei Rastschienen 27 und einem Verriegelungsbügel 19.

Das Basisteil 16 ist ein einstückiges Stanzbiegeteil, das im wesentlichen zwei rechtwinklig zueinander stehende Schenkel hat, von denen der in Einbaulage sich vertikal erstreckende als Frontabdeckung 17 und der andere als Deckplatte 18 dient, die an den beiden Außenkanten noch je eine hochgebogene Seitenwange 19 hat. Die Frontabdeckung 17 weist an den parallelen Außenkanten ebenfalls je einen zur Deckplatte 18 diametral umgebogenen Schenkel auf, die zwei Seitenwände 20 der Andruckvorrichtung 3 bilden und zusammen mit den Seitenwangen 19 der Deckplatte 18 in jeweils einer Ebene liegen.

Am freien Ende ist die Frontabdeckung 17 zur Deckplatte 18 hin winkelförmig gekröpft und die Andruckplatte 21 zwischen den Seitenwänden 20 an der Frontabdeckung 17 befestigt, vorzugsweise mittels Punktschweißen. Durch die winkelförmige Kröpfung erhält die Frontabdeckung 17 einen Absatz mit einer Stufe 22, die zusammen mit der an der Innenseite befestigten Andruckplatte 21 eine offene, im Querschnitt U-förmige Aufnahme bildet. In der geräumig dimensionierten Aufnahme liegt lose auf dem Absatz der Steg eines Verriegelungsbügels 23, der U-Form hat und dessen beide Schenkel 24 an der schmalen Oberkante je eine Reihe sägezahnförmige Rastzähne 25 haben. Der Verriegelungsbügel 23 wird mittels einer Schraube 26 gehalten, die von außen eine Durchgangsbohrung der Stufe 22 durchsetzt und in eine in der Mitte zwischen den Schenkeln 24 angeordnete Gewindebohrung eingedreht ist.

In der unbetätigten Stellung des Verriegelungsbügels 23 ist die Schraube 26 nur wenig eingedreht und die sich bei fest angezogener Schraube 26 in parallelem Abstand oberhalb der Seitenwände 20 erstreckenden Schenkel 24 hängen herab. An den Seitenwänden 20 ist in geringem, parallelen Abstand zur Unterkante je eine Rastschiene 27 befestigt, deren Unterkante eine Reihe ebenfalls sägezahnförmige Rastzähne 28 hat. Weil die Lagen des Kabelbündels wegen der Befestigungslappen 13 für die Druckplatten 10 zwischen den Seitenwänden 6 des Gehäuses 1 exzentrisch durchlaufen, hat die an dieser Seite angeordnete Rastschiene 27 einen stufenförmigen Querschnitt. Der sich mit Abstand parallel zur Seitenwand 20 der Andruckvorrichtung 3 erstreckende und die Rastzähne 28 aufweisende Schenkel verhindert daher ein seitliches Ausweichen von Kabeln 14.

Die Rastschienen 27, die Schenkel 24 des Verriegelungsbügels 23 und die Seitenwände 20 der Frontabdeckung 17 sind gleich lang. Diese Einzelteile sind, wie auch alle anderen Teile von Gehäuse 1, Durchführungsteil 2 und Andruckvorrichtung 3 aus nichtrostendem Stahlblech hergestellt.

Um die Andruckvorrichtung 3 in das Gehäuse 1 einsetzen zu können, ist die Frontplatte 5 unterhalb des Durchführungsteiles 2 etwas schmaler als der Abstand, den die Seitenwände 6 zueinander haben. Daher wird zwischen diesen und dem schmaleren Teil der Frontplatte 5 je ein Schlitz für den Durchtritt der Seitenwände 20 der Andruckvorrichtung 3 gebildet. Außerdem entsteht dadurch am oberen Ende am Übergang zur vollen Breite der Frontplatte 5 je eine Rastschulter 29 zum Hintergreifen der Rastzähne 25 des Verriegelungsbügels 23. Für den Durchtritt der Rastschienen 27 dienen an der Frontplatte 5 seitlich freigeschnittene Ausnehmungen 30, die einen Abstand zum unteren Ende der Frontplatte 5 haben und an der zu diesem Ende weisenden Seite ebenfalls je eine Rastschulter 31 bilden.

Ist das Gehäuse 1 der Kabeldurchführung wie eingangs beschrieben in einem Schrank montiert und sind die erforderlichen Kabel 14 im Durchführungsteil 2 befestigt, wird die Andruckvorrichtung 3, deren Seitenwände 20 lückenlos zwischen die Seitenwände 6 des Gehäuses 1 passen, unterhalb der Druckplatten 10 mit lose hängendem Verriegelungsbügel 23 soweit in das Gehäuse 1 eingeschoben, bis die Andruckplatte 21 an den Schirmgeflechten 15 einer Lage Kabel 14 unter Druck zur Anlage kommt und danach abgesetzt, so daß die Rastzähne 28 der beiden Rastschienen 27 die Rastschultern 31 an der Frontplatte 5 unten hintergreifen. Anschließend wird der Verriegelungsbügel 23 mit der Schraube 26 gegen die Frontabdeckung 17 (Stufe 22) festgezogen, wobei die Schenkel 24 hochschwenken und deren Rastzähne 25 die beiden Rastschultern 29 an der Frontplatte 5 oben hintergreifen. Damit die Andruckplatte 21 die Kabelschirme 15 an definierter Stelle kontaktiert, hat sie in Höhe der Seitenwände 20 eine sich quer erstreckende Sicke 32, die so mit etwa dreieckförmigem Querschnitt eingeformt ist, daß die konvex verlaufende Biegekante nach vorn zur Kabeldurchführung weist. Eine komplementäre Sicke 33 ist auch im unteren Teil der Frontplatte 5 des Gehäuses 1 vorgesehen.

Bei Schränken mit vorläufigem Minderausbau, die in einer entsprechenden Öffnung mehrere nebeneinander befestigte Kabeldurchführungen enthalten und von denen einige zunächst leer bleiben, verschließen die ineinander greifenden Sicken 23, 33 zusammen mit der Deckplatte 18 der Andruckvorrichtung 3 die übrige Öffnung in der Schrankdecke. Um auch zwischen dieser und der Andruckvorrichtung 3 einen elektrisch guten Erdungskontakt sicherzustellen, sind im Randbereich der Deckplatte 18 mehrere Fenster 34 ausgeschnitten, in die entsprechende Kontaktfederbleche (nicht dargestellt) eingehängt werden.

## Patentansprüche

1. Kabeldurchführung für EMV-dicht abgeschirmte Schränke der Nachrichtentechnik, bei denen jeweils oberhalb des Schrankes ankommende, geschirmte Kabel durch eine Öffnung an der Schrankoberseite zu Einrichtungen im Schrank weitergeführt sind, **gekennzeichnet** durch wenigstens eine an einer Schrankwand befestigbare und die Öffnung ausfüllende oder abdeckende Baugruppe, die aus einem Gehäuse (1) mit an der Vorderseite (5) vorgezogenen Seitenwänden (6), einem zwischen diesen an der Vorderseite angebrachten Durchführungsteil (2) mit darin lagenweise festlegbaren Kabeln (14) und einer unterhalb des Durchführungsteiles (2) einsetzbaren und bis an das Schirmgeflecht (15) der Kabel (14) der äußeren Kabellage in das Gehäuse (1) einschiebbaren und am Gehäuse fixierbaren Andruckvorrichtung (3) besteht.

2. Kabeldurchführung nach Anspruch 1, dadurch gekennzeichnet, daß das Durchführungsteil (2) aus einer Grundplatte (7) mit U-förmig hochstehenden Seitenwänden (8, 9) besteht, zwischen denen treppenartig zueinander versetzt mehrere Druckplatten (10) und, mittels dieser, je eine Lage Kabel (14) befestigbar sind.

3. Kabeldurchführung nach Anspruch 2, dadurch gekennzeichnet, daß die Druckplatten (10) jeweils an einem Ende einen Ansatz (11) haben, mit dem sie in treppenartig versetzte Schlitze (12), die in der einen Seitenwand (8) des Durchführungsteiles (2) ausgeschnitten sind, gesteckt und mit dem anderen Ende an nach außen gerichtete Lappen (13) der gegenüberstehenden Seitenwand (9) geschraubt sind.

4. Kabeldurchführung nach Anspruch 2, dadurch gekennzeichnet, daß der Abstand zwischen Grundplatte (7) und nächstliegender Druckplatte (10) sowie zwischen den Druckplatten (10) kleiner als der Durchmesser des blanken Schirmgeflechts (15) der hindurchgeführten Kabel (14) ist.

5. Kabeldurchführung nach Anspruch 1, dadurch gekennzeichnet, daß die Andruckvorrichtung (3) im wesentlichen aus einem Basisteil (16) mit in Einbaulage vertikal stehender Frontabdeckung (17) mit U-förmig umgebogenen Seitenwänden (20), einer Andruckplatte (21), einem Verriegelungsbügel (23), zwei Rastschienen (27) und einer Deckplatte (18) besteht.

6. Kabeldurchführung nach Anspruch 5, dadurch gekennzeichnet, daß der Verriegelungsbügel (23) eine U-Form hat und mit dem beide Schenkel (24) verbindenden Steg lose auf dem Absatz einer am oberen Ende der Frontabdeckung (17) ausgebildeten Stufe (22) liegt und mit einer Schraube (26) fest gegen die Innenschulter der Stufe (22) anziehbar ist.

7. Kabeldurchführung nach Anspruch 6, dadurch gekennzeichnet, daß die Schenkel (24) des Verriegelungsbügels (23) an der Oberkante und die an den Seitenwänden (20) befestigten Rastschienen (27) an der Unterkante eine Reihe Rastzähne (25, 28) haben.

8. Kabeldurchführung nach Anspruch 5, dadurch gekennzeichnet, daß die Deckplatte (18) rechtwinklig von der Frontabdeckung (17) absteht und zwei hochstehende Seitenwangen (19) aufweist, die mit den Seitenwänden (20) der Frontabdeckung (17) in jeweils einer Ebene liegen.

9. Kabeldurchführung nach Anspruch 5 und 6, dadurch gekennzeichnet, daß die Andruckvorrichtung (3) mit den Schenkeln (24) des Verriegelungsbügels (23), den Seitenwänden (20) der Frontabdeckung (17) und mit den an den Seitenwänden (20) angebrachten Rastschienen (27) in entsprechende Schlitze und Ausnehmungen (30) des Gehäuses (1) einsetzbar und bei Betätigen des Verriegelungsbügels (23) durch Festdrehen der Schraube (26) in verschiedenen Raststellungen an Rastschultern (29, 31) des Gehäuses (1) fixierbar ist.

10. Kabeldurchführung nach Anspruch 5, dadurch gekennzeichnet, daß die Andruckplatte (21) zwischen den Seitenwänden (20) an der Frontabdeckung (17) befestigt ist und eine Sicke (32) hat, die beim Einsetzen der Andruckvorrichtung (3) in das Gehäuse (1) ohne Kabel (14), in eine komplementäre Sicke (33) der Frontplatte (5) eingreift und beim Einsetzen in das mit eingelegten Kabeln (14) versehene Gehäuse (1) an der äußeren Kabellage anliegt.

## Claims

1. Cable lead-through for EMI-shielded cabinets used in information technology, in which shielded cables are passed from above the cabinet through an opening on the upper side of the cabinet to devices within the cabinet, characterized by one or more modules, capable of being mounted on a wall of the cabinet and filling or covering the opening, which consists of a housing (1) with forwardly projecting side walls (6) on the front face (5), a lead-through part (2), mounted on the front face between the latter, with cables (14) which can be fastened within it in layers and a pressure device (3) which can be inserted below the lead-through part (2) and pushed into the housing (1) as far as the shielding braid (15) of the cables (14) of the outer cable layer and fixed to the housing.

2. Cable lead-through according to Claim 1, characterized in that the lead-through part (2) consists of a base plate (7) with U-shaped raised side walls (8, 9) between which can be fastened several pressure plates (10) and, by means of each of the latter, one layer of cables (14), offset relative to each other in a step-like arrangement.

3. Cable lead-through according to Claim 2, characterized in that each of the pressure plates (10) has a shoulder (11) at one end by means of which they are inserted into slots (12), offset in a step-like arrangement, cut in one side wall (8) of the lead-through part (2) and is screwed at the other end to outwardly facing tabs (13) of the opposite side wall (9).

4. Cable lead-through according to Claim 2, characterized in that the distance between the base plate (7) and the nearest pressure plate (10) and between the pressure plates (10) is less than the diameter of the bare shielding braid (15) of the cables (14) passing through it.

5. Cable lead-through according to Claim 1, characterized in that the pressure device (3) consists essentially of a base part (16) with a front cover (17), which stands vertically when the unit is in the installed position, having side walls (20) bent in a U-shape, a pressure plate (21) a locking clamp (23), two notched bars (27) and a cover plate (18).

6. Cable lead-through according to Claim 5, characterized in that the locking clamp (23) is U-shaped, its stem joining the two arms (24) lying loosely on the shoulder of a step (22) formed on the upper end of the front cover (17) and can be tightened against the inner shoulder of the step (22) by means of a screw (26).

7. Cable lead-through according to Claim 6, characterized in that the upper edges of the arms (24) of the locking clamp (23) and the lower edges of the notched bars (27) fixed to the side walls (20) have a row of notches (25, 28).

8. Cable lead-through according to Claim 5, characterized in that the cover plate (18) projects at right angles from the front cover (17) and has two raised side faces (19) which each lie in a plane with the side walls (20) of the front cover (17).

9. Cable lead-through according to either of Claims 5 or 6, characterized in that the pressure device (3) can be inserted into appropriate slots and recesses (30) in the housing (1) by means of the arms (24) of the locking clamp (23), the side walls (20) of the front cover (17) and by means of the notched bars (27) mounted on the side walls (20) and, upon operation of the locking clamp (23) by tightening of the screw (26), can be fixed in various notch positions on locking shoulders (29, 31) of the housing (1).

10. Cable lead-through according to Claim 5, characterized in that the pressure plate (21) is fastened between the side walls (20) on the front cover (17) and has a bead (32) which, in the case of the pressure device (3) being inserted into the housing (1) without cables (14), engages with a complementary bead (33) on the front panel (5) and, in the case of the pressure device being inserted into the housing (1) fitted with cables (14), bears on the outer cable layer.

## Revendications

1. Traversée de câbles pour armoires blindées à l'égard des rayonnements électromagnétiques, de la technique des télécommunications, dans le cas desquels, chacun des câbles blindés arrivant au-dessus de l'armoire passe dans l'armoire, pour arriver aux dispositifs, par une ouverture prévue sur la face supérieure de l'armoire, caractérisée par au moins un module qui peut se fixer à une paroi de l'armoire, qui remplit ou recouvre l'ouverture et qui est constitué d'une boîte (1) avec des parois latérales (6) dépassant vers l'avant sur la face avant (5), avec une pièce de traversée (2) qui est rapportée sur la face avant entre ces parois latérales et dans laquelle se trouvent des câbles (14) qui peuvent s'y fixer par couche et avec un dispositif de compression qui peut s'insérer en-dessous de la pièce de traversée (2), s'enfiler dans la boîte (1) jusqu'au treillis de blindage (15) des câbles (14) de la couche extérieure de câbles et se fixer à la boîte.

2. Traversée de câbles selon la revendication 1, caractérisée par le fait que la pièce de traversée (2) est constituée d'une plaque de base (7) avec des parois latérales (8, 9) qui sont dressées en forme de U et entre lesquelles peuvent se fixer plusieurs plaques de compression (10) décalées l'une par rapport à l'autre en escalier et, au moyen de celles-ci, chaque fois une couche de câbles (14).

3. Traversée de câbles selon la revendication 2, caractérisée par le fait que les plaques de compression (10) présentent chacune à une extrémité un embout (11) par lequel elles s'enfilent dans des fentes (12) qui sont décalées en escalier et sont découpées dans la première paroi latérale (8) de la pièce de traversée (2) et, à l'autre extrémité, se vissent contre des pattes (13) orientées vers l'extérieur, de la paroi latérale (9) située en face.

4. Traversée de câbles selon la revendication 2, caractérisée par le fait que la distance entre la plaque de base (7) et la plaque de compression (10) la plus proche ainsi qu'entre les plaques de compression (10) est inférieure au diamètre du treillis de blindage (15), dénudé, des câbles (14) qui traversent.

5. Traversée de câbles selon la revendication 1, caractérisée par le fait que le dispositif de compression (3) est essentiellement constitué d'une partie de base avec un recouvrement frontal (17) placé verticalement en position de montage et présentant des parois latérales (20) repliées en forme de U, d'une plaque de compression (21), d'un étrier de verrouillage (23), de deux rails de crantage (27) et d'une plaque de carrosserie (18).

6. Traversée de câbles selon la revendication 5, caractérisée par le fait que l'étrier de verrouillage (23) a la forme d'un U, que, par l'âme reliant les deux ailes (24), il repose, sans serrage, sur le décrochement d'un échelon (22) prévu à l'extrémité supérieure du recouvrement frontal (17) et peut, au moyen d'une vis (26), se bloquer par vissage contre l'épaulement intérieur de l'échelon (22).

7. Traversée de câbles selon la revendication 6, caractérisée par le fait que les ailes (24) de l'étrier de verrouillage (23) présentent une rangée de dents de crantage (25) aux bords supérieurs et que les rails de crantage (27) fixés aux parois latérales (20) en présentent une (28) au bord inférieur.

8. Traversée de câbles selon la revendication 5, caractérisée par le fait que la plaque de carrosserie (18) vient perpendiculairement en saillie depuis le recouvrement frontal (17) et présente deux joues latérales dressées (19) qui se trouvent chacune dans un même plan avec les parois latérales (20) du recouvrement frontal (17).

9. Traversée de câbles selon les revendications 5 et 6, caractérisée par le fait que le dispositif de compression (3), avec les ailes (24) de l'étrier de verrouillage (23), les parois latérales (20) du recouvrement frontal (17) et avec les rails de crantage (27) rapportées sur les parois latérales (20), peut s'insérer dans des fentes et des évidements appropriés (30) de la boîte (1) et, par manoeuvre de l'étrier de verrouillage (23) et blocage de la vis (26), peut se fixer dans différentes positions de crantage des épaulements de crantage (29, 31) de la boîte (1).

10. Traversée de câbles selon la revendication 5, caractérisée par le fait que la plaque de compression (21) est fixée entre les parois latérales (20) du recouvrement frontal (17) et présente un soyage (32) qui, en cas d'insertion du dispositif de compression (3) dans la boîte (1) sans câble (14), vient en prise dans un soyage complémentaire (33) de la plaque frontale (5) et, en cas d'insertion dans la boîte (1) munie de câbles (14) qui y ont été introduits, s'appuie contre la couche extérieure de câbles.
